# FASCICULE DE BREVET EUROPEEN

(11) **EP 3 098 851 B1**
(45) Date de publication et mention de la délivrance du brevet: **17.03.2021**
(21) Numéro de dépôt: 16170357.4
(22) Date de dépôt: 19.05.2016
(51) Int. Cl.: H01L 27/146

(54) **PROCÉDÉ DE RÉALISATION D'UN FILTRE INFRAROUGE ASSOCIÉ À UN CAPTEUR D'IMAGE**
HERSTELLUNGSVERFAHREN EINES INFRAROT-FILTERS IN VERBINDUNG MIT EINEM BILDSENSOR
METHOD FOR PRODUCING AN INFRARED FILTER ASSOCIATED WITH AN IMAGE SENSOR

(30) Priorité: 28.05.2015 FR 1554830
(43) Date de publication de la demande: 30.11.2016
(73) Titulaire: COMMISSARIAT À L'ÉNERGIE ATOMIQUE ET AUX ÉNERGIES ALTERNATIVES, 75015 Paris (FR)
(72) Inventeur: FREY, Laurent, 38600 FONTAINE (FR); MARTY, Michel, 38760 SAINT-PAUL DE VARCES (FR); MASAROTTO, Lilian, 38600 FONTAINE (FR)
(74) Mandataire: Cabinet Beaumont

(56) Documents cités:
- EP-A1- 2 835 671
- EP-A1- 2 851 955
- US-A1- 2008 090 323
- US-A1- 2009 008 730
- US-A1- 2009 298 220

## Description

### Domaine

La présente demande concerne un procédé de réalisation d'un filtre infrarouge associé à un capteur d'image.

### Exposé de l'art antérieur

On considère ici des capteurs d'image constitués d'une matrice de pixels.

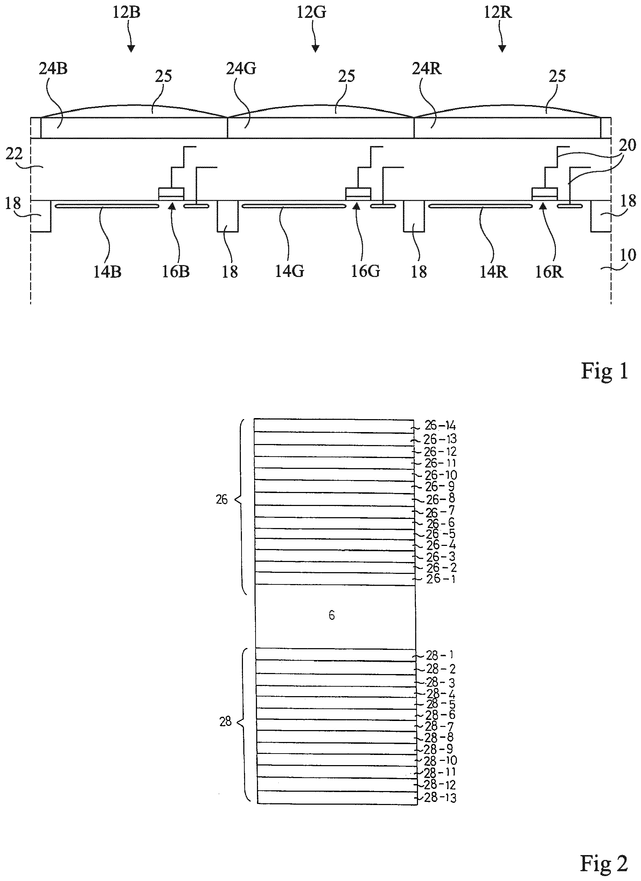

La figure 1 représente schématiquement trois pixels d'une matrice de pixels d'un capteur d'image couleur classique. Sur un substrat semiconducteur 10 sont formés des pixels de différentes couleurs, dans l'exemple représenté un pixel bleu 12B, un pixel vert 12G et un pixel rouge 12R. Chaque pixel comprend une zone de photodétection 14B, 14G, 14R formée dans le substrat 10. Des éléments de transfert de charges 16B, 16G, 16R, dans l'exemple représenté des transistors MOS, sont prévus. Les zones de photodétection sont isolées les unes des autres par des tranchées isolantes 18 formées dans le substrat 10.

Au-dessus du substrat 10 est prévu un empilement de niveaux d'interconnexion comprenant des pistes métalliques 20 noyées dans un matériau isolant 22. Des filtres colorés 24B, 24G, 24R sont formés en surface de l'empilement de niveaux d'interconnexion et sont recouverts de microlentilles 25. On prévoit aussi parfois des pixels munis de filtres sélectionnant une bande dans le domaine du rouge ou du proche infrarouge, notamment dans une plage de longueurs d'onde comprises entre 600 nm et 1100 nm, par exemple pour des mesures de distance entre le capteur et un objet, auquel cas la bande passante doit être étroite pour supprimer le signal provenant de la scène.

Par ailleurs, il est connu que des filtres interférentiels peuvent être obtenus par dépôts successifs d'une alternance de couches diélectriques d'indices optiques faible et élevé. Le nombre de couches alternées ainsi que leurs épaisseurs déterminent les propriétés du filtre.

Comme le représente la figure 2 qui correspond à la figure 10 du brevet US N°5398133, un filtre passe-bande infrarouge a été réalisé par l'association d'un filtre passe-haut 26 et d'un filtre passe-bas 28. Une alternance de couches (26-1 à 26-14) de silicium amorphe (indice optique élevé) et de nitrure de silicium (indice optique faible) forme le filtre passe-haut sur un support de verre 6. Une alternance de couches (28-1 à 28-13) des mêmes matériaux forme le filtre passe-bas sur le support de verre 6. L'épaisseur de chaque couche est différente. Ce type de filtre a pour avantage d'avoir une transmission élevée et une bande passante étroite.

De tels filtres peuvent être déposés en surface des niveaux d'interconnexion d'un capteur d'image, mais ne permettent pas de filtrer une bande du visible, notamment dans une plage de longueurs d'onde comprises entre 400 nm et 600 nm, en raison de l'absorption du silicium amorphe. Un autre inconvénient du filtre décrit dans le document US N°5398133 est qu'il comprend de nombreuses couches et a une épaisseur totale élevée. Un autre inconvénient est que, si on dépose un tel filtre en surface des niveaux d'interconnexion d'un capteur d'image, la présence du filtre éloigne d'autant les microlentilles du substrat de silicium. Il peut alors être difficile d'obtenir une focalisation efficace.

Le document US 2009/298220 décrit un procédé de fabrication d'un capteur d'images CMOS. Le document EP 2 851 955 décrit un procédé de réalisation d'un filtre optique au sein d'un circuit intégré. Le document US 2008/090323 décrit un procédé de réalisation de filtres de couleur.

### Résumé

Il existe un besoin d'un capteur d'image incorporant des filtres dans l'infrarouge et éventuellement, en outre, dans le visible, de structure simple.

Ainsi, un mode de réalisation prévoit un procédé de réalisation simultanée d'un filtre passe-bande dans l'infrarouge d'un côté filtre, et de niveaux d'interconnexions d'un côté interconnexion d'un capteur d'image, selon la revendication 1.

Selon le mode de réalisation, les étapes a), b), c), d), e), f), g) et h) sont successives.

Selon un mode de réalisation, le silicium est du silicium amorphe.

Selon un mode de réalisation, le matériau diélectrique est de l'oxyde de silicium.

Selon un mode de réalisation, les première et deuxième couches et la couche de silicium sont déposées à une température comprise entre 350°C et 400°C.

Selon un mode de réalisation, les première et deuxième couches et la couche de silicium sont déposées à la même température.

Selon un mode de réalisation, le procédé comprend, en outre, l'étape consistant à éliminer la couche d'arrêt de gravure du côté filtre avant de procéder à l'étape c).

Selon un mode de réalisation, ladite au moins une couche de silicium comprend une alternance de couches de silicium amorphe et de couches d'oxyde de silicium.

Selon un mode de réalisation, la couche d'arrêt de gravure est en nitrure de silicium, en SiCH, ou en SiOCH.

Selon un mode de réalisation, le procédé comprend, en outre, la formation, avant l'étape b), d'une connexion électrique avec un élément du substrat semiconducteur ou avec une grille d'un transistor à effet de champ formée sur le substrat semiconducteur.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1, décrite précédemment, illustre la structure d'un capteur d'image couleur classique ;
la figure 2, décrite précédemment, est une vue en coupe d'un filtre interférentiel infrarouge ;
les figures 3A à 3J illustrent des étapes successives d'un premier mode de réalisation d'un procédé de fabrication simultanée de niveaux d'interconnexion et de niveaux d'un filtre infrarouge d'un capteur d'image ;
les figures 4A à 4E illustrent des étapes successives d'un deuxième mode de réalisation d'un procédé de fabrication simultanée de niveaux d'interconnexion et de niveaux d'un filtre infrarouge d'un capteur d'image ;
les figures 5A à 5E illustrent des étapes successives d'un troisième mode de réalisation d'un procédé de fabrication simultanée de niveaux d'interconnexion et de niveaux d'un filtre infrarouge d'un capteur d'image ;
la figure 6A illustre une vue en coupe d'un mode de réalisation d'un capteur d'image ;
la figure 6B est un diagramme représentant la transmission du filtre infrarouge représenté en figure 6A dans différentes configurations ;
les figures 7 à 9 représentent des vues en coupe d'autres modes de réalisation d'un capteur d'image ;
la figure 10 représente une application possible d'un mode de réalisation d'un capteur d'image destiné à être éclairé par la face arrière ; et
la figure 11 représente, de façon partielle et schématique, un exemple d'un système de mesure de distance.

### Description détaillée

De mêmes éléments ont été désignés par de mêmes références aux différentes figures et, de plus, les diverses figures ne sont pas tracées à l'échelle. Par souci de clarté, seuls les éléments qui sont utiles à la compréhension des modes de réalisation décrits ont été représentés et sont détaillés ici.

Dans la description qui suit, lorsque l'on fait référence à des qualificatifs de position absolue, tels que les termes "gauche", "droite", ou relative, tels que les termes "dessus", "dessous", ou à des qualificatifs d'orientation, tels que le terme "vertical", il est fait référence à l'orientation des figures. Sauf précision contraire, les mots "environ", "sensiblement" signifient à 10 % près, de préférence à 5 % près.

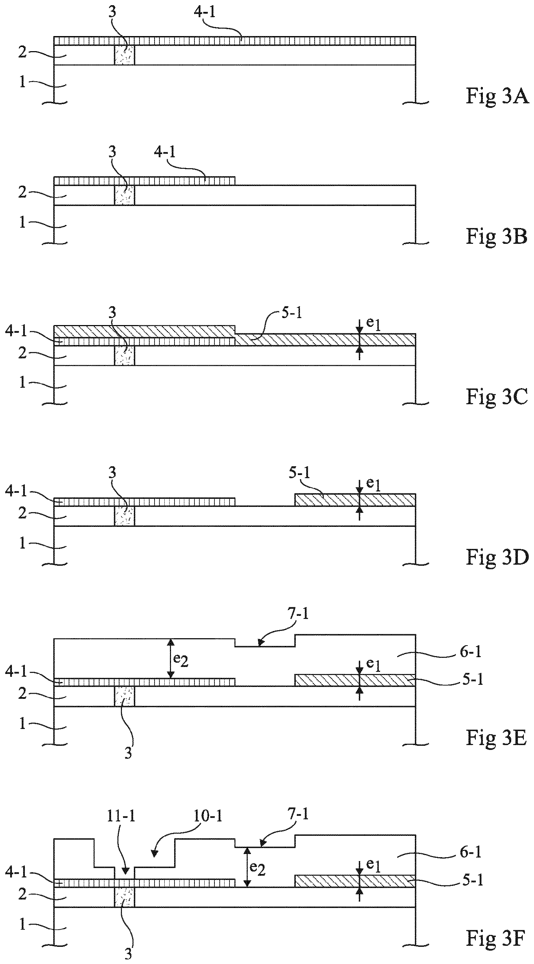

Les figures 3A à 3J illustrent des étapes d'un premier mode de réalisation d'un procédé de fabrication simultanée d'une alternance de couches formant, d'une part, des niveaux d'interconnexion (côté gauche des figures) et, d'autre part, un filtre infrarouge (côté droit des figures).

Ce procédé s'applique notamment au cas où on veut réaliser un capteur d'image dont la structure comprend au moins un pixel dédié à l'infrarouge. La description suivante sera faite dans le cas particulier où un substrat semiconducteur 1 a préalablement été revêtu d'une couche isolante 2, par exemple en oxyde de silicium (SiO₂), dans laquelle une connexion électrique 3 avec un élément du substrat semiconducteur 1 ou une grille de transistor MOS a été préparée.

Dans une première étape illustrée en figure 3A, on a déposé une couche d'arrêt de gravure 4-1 sur la couche 2 de SiO₂.

A l'étape de la figure 3B, on a retiré la couche d'arrêt de gravure 4-1 du côté droit afin qu'elle recouvre la couche 2 de SiO₂ seulement du côté gauche.

A l'étape de la figure 3C, on a déposé une couche 5-1 de silicium amorphe (α-Si), d'épaisseur e₁.

A l'étape de la figure 3D, on a retiré par gravure la couche 5-1 de α-Si du côté gauche afin qu'elle recouvre la couche 2 de SiO₂ seulement du côté droit.

A l'étape de la figure 3E, on a déposé une couche 6-1 d'un matériau diélectrique ayant un indice de réfraction faible à la longueur d'onde de 850 nm, notamment dont l'indice de réfraction est inférieur à 2,5, de préférence inférieur à 2, d'épaisseur e₂ supérieure à l'épaisseur e₁. Le matériau diélectrique peut être le SiO₂ ou un diélectrique à faible permittivité (low-k), c'est-à-dire dont la permittivité relative est inférieure à celle de SiO₂ qui est d'environ 3, 6 à 850 nm, notamment un matériau de type minéral à base de Si-O, comportant des radicaux organiques ou hydrures, tels que décrits dans le brevet EP 1 109 221. On a désigné par la référence 7-1 la surface supérieure de la couche 6-1, là où cette couche 6-1 ne recouvre aucune des couches 4-1 et 5-1. Dans le cas où le matériau diélectrique est le SiO₂, la couche d'arrêt de gravure est par exemple une couche de nitrure de silicium (SiN) . Dans le cas où le matériau diélectrique est un matériau à faible permittivité, la couche d'arrêt de gravure est par exemple une couche de SiCH ou de SiOCH.

A l'étape de la figure 3F, on a gravé du côté gauche une portion de la couche 6-1 de SiO₂ formant un évidement 10-1 de profondeur inférieure à e₂. On a réalisé, à la verticale de la connexion 3, une seconde gravure dans l'évidement 10-1 jusqu'à la couche d'arrêt de gravure 4-1, formant un évidement 11-1 plus étroit que l'évidement 10-1. On comprendra que l'on peut réaliser simultanément plusieurs évidements de formes et de tailles différentes.

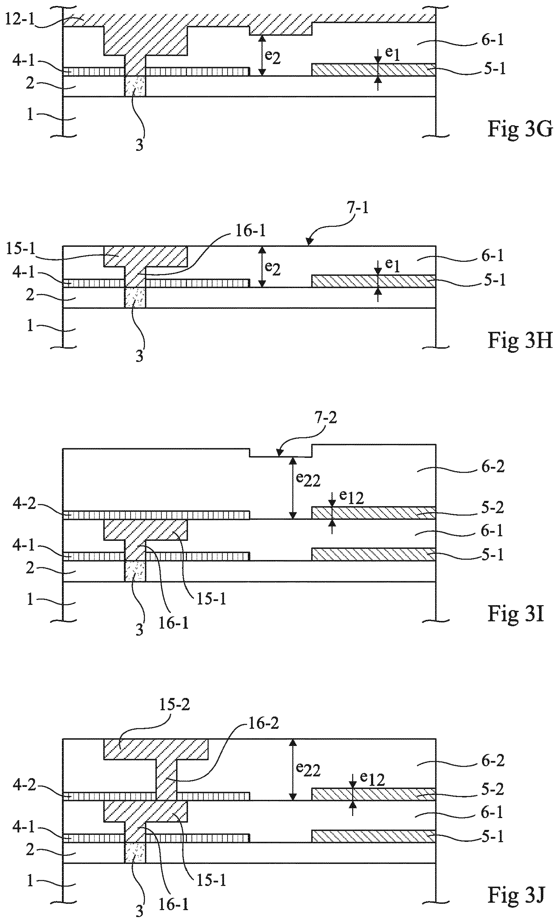

A l'étape de la figure 3G, on a retiré la portion de la couche d'arrêt de gravure 4-1 située au fond de l'évidement 11-1, puis on a déposé un métal 12-1, par exemple du cuivre, entrant en contact avec la connexion 3 au fond de l'évidement 11-1. De façon classique, ce dépôt pourra être précédé du dépôt de couches barrière de diffusion (non représentées), par exemple des couches de Ti, Ta, TiN, TaN.

A l'étape de la figure 3H, on a réalisé une planarisation de la structure pour éliminer toutes les couches situées au-dessus de la surface 7-1. Cette planarisation pourra être réalisée, par exemple, par un procédé de polissage mécano-chimique (CMP). Le métal 12-1 restant dans les évidements 10-1 et 11-1 forme respectivement une piste conductrice 15-1 et un via 16-1 reliant la piste 15-1 à la connexion 3.

A titre de variante, la formation de la couche 6-1 de SiO₂ peut comprendre successivement le dépôt d'une première sous-couche de SiO₂, le dépôt d'une couche d'arrêt de gravure, par exemple en SiN, et le dépôt d'une deuxième sous-couche de SiO₂. L'épaisseur totale de la première sous-couche de SiO₂ et de la couche d'arrêt de gravure est égale à l'épaisseur souhaitée du via 16-1 et l'épaisseur de la deuxième sous-couche de SiO₂ est égale à l'épaisseur de la piste 15-1. Ceci permet de mieux maîtriser les épaisseurs de chaque couche de SiO₂.Un exemple de procédé de fabrication de la piste conductrice 15-1 et du via 16-1 par un procédé comprenant le dépôt de plusieurs sous-couches isolantes est décrit dans le brevet EP 1 109 221.

La figure 3I illustre une répétition de la succession d'étapes des figures 3A à 3E, sur la structure de la figure 3H. Ainsi on a procédé à la succession d'étapes suivante :
- dépôt d'une couche d'arrêt de gravure 4-2 sur la couche 6-1 ;
- retrait de la couche d'arrêt de gravure 4-2 du côté droit ;
- dépôt d'une couche 5-2 de α-Si d'épaisseur e₁₂ ;
- retrait de la couche 5-2 de α-Si du côté gauche ; et
- dépôt d'une couche 6-2 de SiO₂ d'épaisseur e₂₂ supérieure à l'épaisseur e₁₂. On a désigné par la référence 7-2 la surface supérieure de la couche 6-2, là où cette couche 6-2 ne recouvre aucune des couches 4-2 et 5-2.

La figure 3J illustre le résultat de la succession d'étapes des figures 3F à 3H sur la structure de la figure 3I. Ainsi on a procédé à la succession d'étapes suivante :
- gravure dans la couche 6-2 de SiO₂, du côté interconnexion, d'un premier évidement de profondeur inférieure à e₂₂ ;
- gravure, à l'intérieur du premier évidement, d'un second évidement dans la couche 6-2, plus étroit que le premier évidement, jusqu'à la couche d'arrêt de gravure 4-2 ;
- retrait de la portion de la couche d'arrêt de gravure 4-2 se trouvant au fond du second évidement ;
- dépôt d'une couche de métal formant, dans les évidements, une piste conductrice 15-2 et un via 16-2 reliant la piste 15-2 à la piste 15-1 ; et
- planarisation de la structure au niveau de la surface 7-2.

On a ainsi formé, en utilisant des étapes communes, un empilement de deux niveaux d'interconnexion du côté gauche de la figure et un empilement de deux niveaux de filtre infrarouge du côté droit de la figure.

L'alternance de couches de SiO₂ et de silicium amorphe constitue un filtre infrarouge dont les propriétés de filtrage dépendent du nombre de couches et de leurs épaisseurs.

S'il est prévu une structure à plus de deux niveaux d'interconnexion, le processus sera répété et le nombre de couches alternées de silicium amorphe et de SiO₂ sera augmenté. Des logiciels de simulation optique sont utilisés pour déterminer les épaisseurs des couches de silicium amorphe pour former des filtres infrarouges aux propriétés désirées, en fonction des épaisseurs de SiO₂ optimisées pour obtenir les performances électriques souhaitées, notamment en matière de capacités parasites inter-niveaux, en fonction de la densité d'interconnexion atteignable.

A titre de variante, s'il est prévu une structure à plus de deux niveaux d'interconnexion, une couche de silicium amorphe peut ne pas être présente à chaque niveau d'interconnexion.

Les inventeurs ont mis en évidence que, de façon surprenante, il est possible d'obtenir un filtre infrarouge ayant une réponse spectrale convenable, malgré le faible nombre de couches du filtre infrarouge, et malgré les contraintes spécifiques dues au fait que le filtre infrarouge est réalisé simultanément à des niveaux d'interconnexion, notamment le fait que chaque couche 6-1, 6-2 de SiO₂ a une épaisseur imposée après planarisation par les performances électriques visées des niveaux d'interconnexion et que la position de la base de chaque couche 5-1, 5-2 de α-Si est imposée par les performances électriques visées des niveaux d'interconnexion.

Si la couche isolante 2 ou les couches isolantes 6-1, 6-2 comprenaient des flancs abrupts résultant notamment d'une gravure, il y aurait un risque, lors de la gravure de la couche 5-1, 5-2 de silicium amorphe déposée de façon conforme, qu'il demeure de façon non souhaitée du silicium amorphe sur les flancs abrupts de la couche isolante. De façon avantageuse, dans le présent mode de réalisation, la couche isolante 2, 6-1, 6-2 est sensiblement plane et ne comprend pas de flancs abrupts.

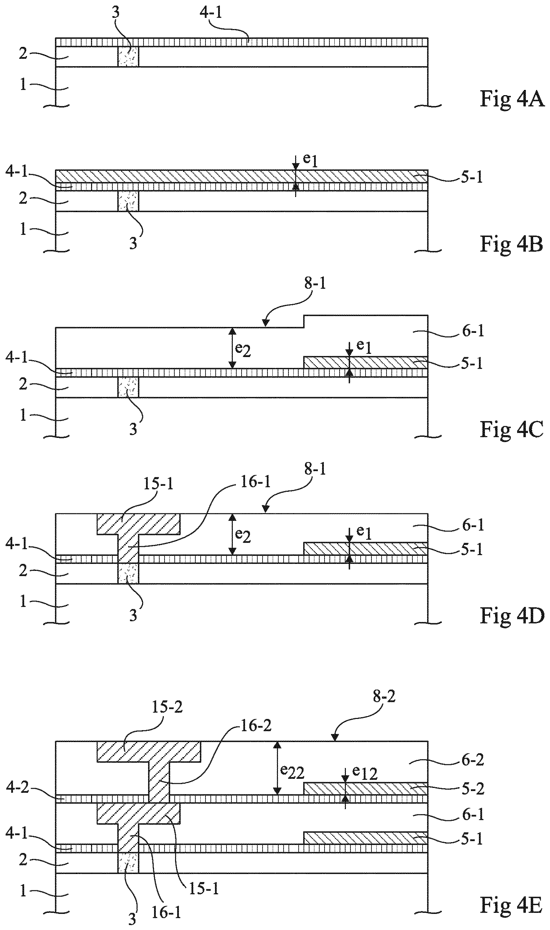

Les figures 4A à 4E illustrent des étapes d'un deuxième mode de réalisation d'un procédé de fabrication simultanée d'une alternance de couches formant, d'une part, un filtre infrarouge et, d'autre part, des niveaux d'interconnexion d'une structure de capteur d'image sur un substrat semiconducteur 1.

Comme l'illustre la figure 4A, on part d'une structure identique à celle décrite précédemment en relation avec la figure 3A.

A l'étape de la figure 4B, on a déposé une couche 5-1 de silicium amorphe (a-Si), d'épaisseur e₁, sur la couche d'arrêt de gravure 4-1.

A l'étape de la figure 4C, on a effectué la succession d'étapes suivante :
- retrait par gravure de la couche 5-1 de α-Si du côté gauche afin qu'elle recouvre la couche 4-1 d'arrêt de gravure seulement du côté droit, cette couche d'arrêt de gravure n'étant pas gravée ; et
- dépôt d'une couche 6-1 de SiO₂ d'épaisseur e₂ supérieure à e₁. On a désigné par la référence 8-1 la surface supérieure de la couche 6-1, là où cette couche 6-1 ne recouvre pas la couche 5-1 de α-Si.

A l'étape de la figure 4D, on a effectué la succession d'étapes suivante :
- gravure dans la couche 6-1 de SiO₂, du côté gauche, d'un premier évidement de profondeur inférieure à e₂ ;
- gravure, à l'intérieur du premier évidement et en regard de la connexion 3, d'un second évidement dans la couche 6-1, plus étroit que le premier, jusqu'à la couche d'arrêt de gravure 4-1 ;
- retrait de la portion de la couche d'arrêt de gravure 4-1 se trouvant au fond du second évidement ;
- dépôt d'une couche de métal formant, dans les évidements, une piste conductrice 15-1 et un via 16-1 reliant la piste 15-1 à la connexion 3 ; et
- planarisation de la structure au niveau de la surface 8-1.

A l'étape de la figure 4E, on a répété la succession d'étapes des figures 4A à 4D sur la structure de la figure 4D. Ainsi on a procédé à la succession d'étapes suivante :
- dépôt d'une couche d'arrêt de gravure 4-2 sur la couche 6-2 de SiO₂ ;
- dépôt d'une couche 5-2 de α-Si d'épaisseur e₁₂ ;
- retrait de la couche 5-2 de α-Si du côté gauche ;
- dépôt d'une couche 6-2 de SiO₂ d'épaisseur e₂₂ supérieure à l'épaisseur e_{12.} On a désigné par la référence 8-2 la surface supérieure de la couche 6-2, là où cette couche 6-2 ne recouvre pas la couche 5-2 de α-Si ;
- gravure dans la couche 6-2 de SiO₂, du côté gauche, d'un premier évidement de profondeur inférieure à e₂₂ ;
- gravure à l'intérieur du premier évidement d'un second évidement dans la couche 6-2, plus étroit que le premier, jusqu'à la couche d'arrêt de gravure 4-2 ;
- retrait de la portion de la couche d'arrêt de gravure 4-2 se trouvant au fond du second évidement ;
- dépôt d'une couche de métal formant, dans les évidements, une piste conductrice 15-2 et un via 16-2 reliant la piste 15-2 à la piste 15-1 ; et
- planarisation de la structure au niveau de la surface 8-2.

On a ainsi formé, en utilisant des étapes communes, un empilement de deux niveaux d'interconnexion du côté gauche de la figure et un empilement de deux niveaux de filtre infrarouge du côté droit de la figure.

Comme dans le cas des figures 3A à 3J, s'il est prévu plus de deux niveaux d'interconnexion, le processus sera répété et le nombre de couches alternées de silicium amorphe, de SiO₂ et d'arrêt de gravure sera augmenté. De même, des logiciels de simulation sont utilisés pour déterminer les épaisseurs des couches de silicium amorphe, en fonction des épaisseurs des couches de SiO₂ et d'arrêt de gravure imposées par la réalisation des niveaux d'interconnexion, pour former des filtres infrarouges aux propriétés désirées. Comme dans le cas des figures 3A à 3J, s'il est prévu une structure à plus de deux niveaux d'interconnexion, une couche de silicium amorphe peut ne pas être présente à chaque niveau d'interconnexion.

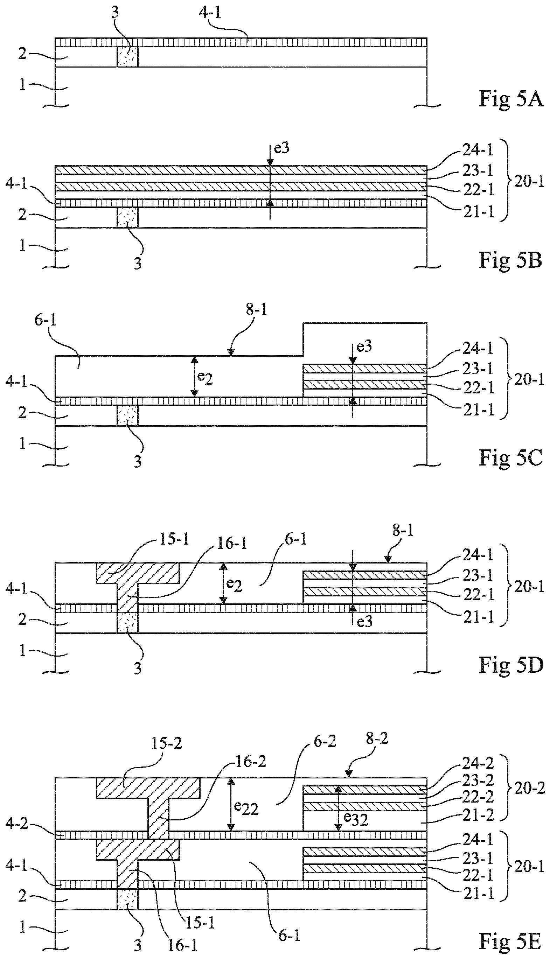

Les figures 5A à 5E illustrent des étapes d'un troisième mode de réalisation d'un procédé de fabrication simultanée d'une alternance de couches formant, d'une part, un filtre infrarouge et, d'autre part, des niveaux d'interconnexion d'une structure de capteur d'image sur un substrat semiconducteur 1.

Comme l'illustre la figure 5A, on part d'une structure identique à celle décrite précédemment en relation avec la figure 3A.

A l'étape de la figure 5B, au lieu de déposer une couche unique de silicium amorphe (a-Si) comme dans le cas des figures 3C et 4B, on a déposé une alternance 20-1 de couches de SiO₂ et de α-Si sur la couche d'arrêt de gravure 4-1. Cette alternance 20-1 de couches comprend, dans l'exemple représenté, une couche de SiO₂ 21-1, une couche de α-Si 22-1, une autre couche de SiO₂ 23-1, et une autre couche de α-Si 24-1. L'alternance 20-1 de couches a une épaisseur totale e₃.

A l'étape de la figure 5C, on a effectué la succession d'étapes suivante :
- retrait de l'alternance de couches 20-1 du côté gauche ; et
- dépôt d'une couche 6-1 de SiO₂ d'épaisseur e₂ supérieure à l'épaisseur e₃. On a désigné par la référence 8-1 la surface supérieure de la couche 6-1, là où cette couche 6-1 ne recouvre pas l'alternance de couches 20-1.

A l'étape de la figure 5D, on a effectué la succession d'étapes suivante :
- gravure dans la couche 6-1 de SiO₂, du côté gauche, d'un premier évidement de profondeur inférieure à l'épaisseur e₂ ;
- gravure, à l'intérieur du premier évidement et à la verticale de la connexion 3, d'un second évidement dans la couche 6-1, plus étroit que le premier, jusqu'à la couche d'arrêt de gravure 4-1 ;
- retrait de la portion de la couche d'arrêt de gravure 4-1 se trouvant au fond du second évidement ;
- dépôt d'une couche de métal formant, dans les évidements, une piste conductrice 15-1 et un via 16-1 reliant la piste 15-1 à la connexion 3 ; et
- planarisation de la structure au niveau de la surface 8-1.

A l'étape de la figure 5E, on a répété la succession d'étapes des figures 5A à 5D sur la structure de la figure 5D. Ainsi on a procédé à la succession d'étapes suivante :
- dépôt d'une couche d'arrêt de gravure 4-2 sur la couche 6-1 ;
- dépôt d'une alternance de couches 20-2 de SiO₂ et de α-Si sur la couche d'arrêt de gravure 4-2. Cette alternance de couches 20-1 comprend, dans l'exemple représenté, une couche de SiO₂ 21-1, une couche de α-Si 22-1, une autre couche de SiO₂ 23-1, et une autre couche de α-Si 24-1. L'alternance de couches 20-1 est d'épaisseur totale e₃₂ ;
- retrait de l'alternance de couches 20-2 du côté gauche ;
- dépôt d'une couche 6-2 de SiO₂ d'épaisseur e₂₂ supérieure à l'épaisseur e_{32.} On a désigné par la référence 8-2 la surface supérieure de la couche 6-2, là où cette couche 6-2 ne recouvre pas l'alternance de couches 20-2 ;
- gravure dans la couche 6-2 de SiO₂, du côté gauche, d'un premier évidement de profondeur inférieure à l'épaisseur e₃₂ ;
- gravure d'un second évidement dans la couche 6-2, plus étroit et situé à l'intérieur du premier évidement, jusqu'à la couche d'arrêt de gravure 4-2 ;
- retrait de la portion de la couche d'arrêt de gravure 4-2 se trouvant au fond du second évidement ;
- dépôt d'une couche de métal formant, dans les évidements, une piste conductrice 15-2 et un via 16-2 reliant la piste 15-2 à la piste 15-1 ; et
- planarisation de la structure au niveau de la surface 8-2.

On a ainsi formé, en utilisant des étapes communes, un empilement de deux niveaux d'interconnexion du côté gauche de la figure et un empilement de plusieurs niveaux de filtre infrarouge du côté droit de la figure.

Comme dans le cas des figures 3A à 3J et 4A à 4E, s'il est prévu plus de deux niveaux d'interconnexion, le processus sera répété et le nombre de couches alternées de silicium amorphe, de SiO₂ et d'arrêt de gravure sera augmenté. Des logiciels de simulation sont utilisés pour déterminer les épaisseurs des couches alternées de silicium amorphe et de SiO₂, en fonction des épaisseurs des couches de SiO₂ et des couches d'arrêt de gravure imposées par la réalisation des niveaux d'interconnexion, pour former des filtres infrarouges aux propriétés désirées.

Dans les modes de réalisation exposés précédemment, les dépôts des différentes couches doivent être réalisés à une température inférieure ou égale à 400°C pour éviter d'endommager les couches formant les interconnexions déjà présentes. Les couches de métal, d'oxyde de silicium et de silicium amorphe sont, par exemple, réalisées par dépôt physique en phase vapeur (PVD). A titre de variante, les couches d'oxyde de silicium et de silicium amorphe peuvent être déposées par dépôt chimique en phase vapeur assisté par plasma (PECVD). Dans ce cas, la température de dépôt de ces deux matériaux empilés en alternance dans le filtre doit être identique et supérieure à 350°C pour amener une stabilité mécanique, morphologique et thermique aux empilements. Cette méthode de dépôt est avantageuse dans le cadre d'un processus comprenant un recuit final à environ 400°C. En effet les inventeurs ont constaté une tendance à la délamination à certaines interfaces de α-Si et de SiO₂ après recuit à 400°C, pour des niveaux de filtre déposés à une température inférieure à 350°C en PECVD.

Dans les modes de réalisation exposés précédemment, les épaisseurs e₂, e₂₂ des couches de SiO₂ ont des valeurs sensiblement comprises entre 150 nm et 650 nm. Les épaisseurs e₁, e₁₂, (ou e₃, e₃₂) des couches de silicium amorphe (ou des alternances de couches de α-Si et de SiO₂) ont des valeurs sensiblement comprises entre 50 nm et 200 nm. Les couches d'arrêt de gravure ont des valeurs sensiblement comprises entre 20 nm et 50 nm.

L'épaisseur totale d'une superposition de couches déposées selon un mode de réalisation du procédé décrit précédemment est sensiblement comprise entre 0,5 µm et 10 µm, préférentiellement entre 1 µm et 3 µm.

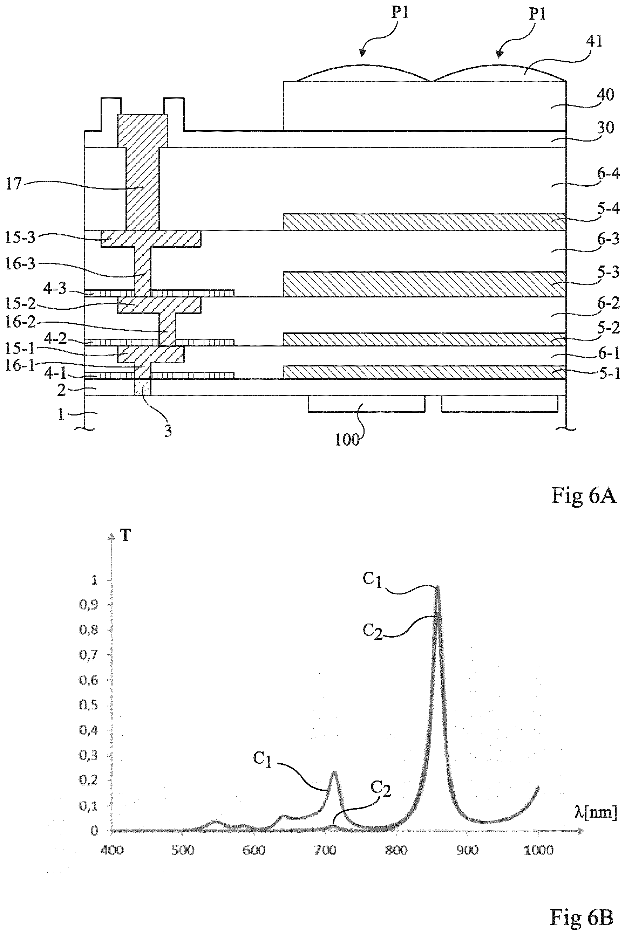

La figure 6A est une vue en coupe d'un capteur d'images formé sur un substrat semiconducteur 1 comprenant des zones de photodétection 100. Le substrat est revêtu d'une couche 2 de SiO₂ dans laquelle une connexion 3 avec un élément du substrat semiconducteur 1 ou une grille de transistor MOS a été préparée. Un empilement de niveaux d'interconnexion est représenté du côté gauche de la figure et un empilement de niveaux de filtre est représenté du côté droit de la figure. Ces empilements sont formés selon un procédé correspondant au premier mode de réalisation décrit en relation avec les figures 3A à 3J.

Le côté gauche de la figure 6A correspond à un empilement de quatre niveaux d'interconnexion similaires aux niveaux d'interconnexion représentés sur le côté gauche de la figure 3J. Cet empilement de niveaux comprend des pistes conductrices 15-1, 15-2, 15-3 séparées les unes des autres par des couches isolantes 6-1, 6-2, 6-3, 6-4 et reliées entre elles par des vias 16-1, 16-2, 16-3 traversant les couches isolantes. A titre d'exemple de réalisation, le dernier niveau d'interconnexion comprend un plot de connexion 17 faisant saillie à la surface de la partie supérieure du capteur d'image. Cette configuration d'interconnexion a été représentée uniquement à titre d'exemple. Diverses configurations de niveaux d'interconnexion sont possibles.

Le côté droit de la figure correspond à deux pixels dédiés à l'infrarouge P1. Ce côté comprend un empilement de quatre niveaux de filtre similaires aux niveaux de filtre représentés du côté droit de la figure 3J. Cet empilement de niveaux comprend une alternance de couches isolantes 2, 6-1, 6-2, 6-3, 6-4 et de couches de silicium amorphe 5-1, 5-2, 5-3, 5-4 formant un filtre infrarouge.

De façon classique, au moins une couche de passivation 30 est déposée à la surface des niveaux d'interconnexion et de filtre. La couche 30 est ouverte en regard du plot 17. Un recuit final, par exemple de 2 heures à 400°C en atmosphère de N₂H₂, peut être réalisé après le dépôt de la couche 30.

Une couche de résine 40 sensiblement opaque pour la lumière visible et transparente aux infrarouges, couramment appelée "résine noire", a été déposée à la surface de la couche de passivation 30 à droite sur la figure, au-dessus de l'empilement de niveaux de filtre. Une microlentille 41 est disposée sur la couche de résine 40, à la verticale de chaque zone de photodétection 100. Chaque pixel P1 comprend une zone de photodétection, un filtre infrarouge, une couche de résine noire et une microlentille.

La figure 6B est un diagramme représentant la transmission T du filtre de la figure 6A, en fonction de la longueur d'onde λ. La courbe C1 correspond à la transmission du filtre sans résine noire 40 et la courbe C2 correspond à la transmission du filtre en présence d'une couche de résine noire 40. La résine noire 40 permet de supprimer la transmission parasite du filtre dans le domaine du visible. Ces courbes correspondent au cas où les épaisseurs des couches déposées sont les suivantes :

| couche | 2 | 5-1 | 6-1 | 5-2 | 6-2 | 5-3 | 6-3 | 5-4 | 6-4 |
|---|---|---|---|---|---|---|---|---|---|
| épaisseur (nm) | 390 | 50 | 100 | 50 | 330 | 180 | 430 | 80 | 570 |

Dans cette configuration, le pic de transmission est à une longueur d'onde de sensiblement 850 nm et est supérieur à 80 %. La largeur à mi-hauteur de ce pic vaut sensiblement 25 nm. Ces performances sont compatibles avec l'utilisation du capteur d'images comme capteur de distance mettant en oeuvre un procédé de mesure de temps de vol ou TOF (acronyme anglais pour Time Of Flight) dans lequel la largeur à mi-hauteur du pic doit généralement être comprise entre 20 nm et 50 nm et le maximum de transmission doit être supérieur à 80 %.

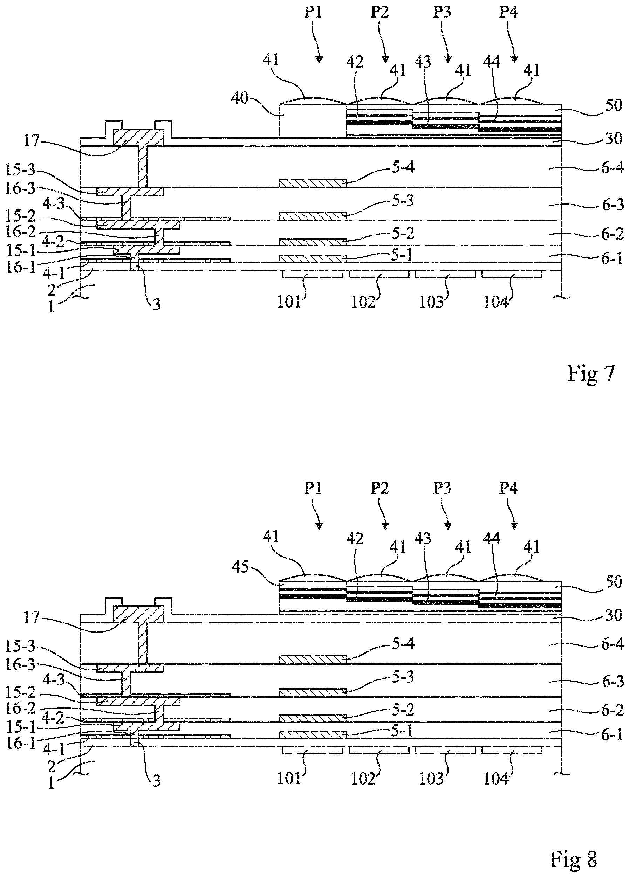

La figure 7 est une représentation en coupe d'un capteur d'image formé sur un substrat semiconducteur 1 comprenant des zones de photodétection 101, 102, 103 et 104.

Le côté gauche de la figure, comprenant des niveaux d'interconnexion et un pixel P1 muni d'un filtre infrarouge, est identique à la représentation de la figure 6A (pour un seul pixel P1). Les éléments communs portent les mêmes références et ne seront pas détaillés à nouveau ici.

La partie droite de la figure représente des pixels P2, P3, P4, dédiés au visible, chacun étant muni d'un filtre du domaine visible 42, 43, 44 disposé à la verticale des zones de photodétection 102, 103 et 104. Les trois filtres 42, 43, 44 filtrent respectivement les couleurs rouge, verte et bleue (RGB). Ces filtres sont par exemple du type illustré en figure 4B de la demande de brevet US N°2012/0085944 du demandeur, et comportant une alternance de couches de métal suffisamment fines pour être transparentes et de couches diélectriques. Les couches diélectriques sont choisies pour laisser passer les couleurs choisies (RGB).

Une couche de planarisation 50 met à un niveau unique la surface au-dessus des trois filtres 42, 43, 44 et de la couche de résine noire 40. Pour chacun des pixels P1, P2, P3 et P4, une microlentille 41 est disposée sur la surface plane formée par la couche 50. Selon un mode de réalisation, la couche de résine noire 40 peut être formée après la formation des filtres 42, 43, 44 et de la couche de planarisation 50.

La figure 8 illustre une variante de réalisation d'un capteur d'image similaire à celui de la figure 7, comprenant des niveaux d'interconnexion, un pixel dédié à l'infrarouge et trois pixels dédiés au visible. Les éléments communs aux figures 8 et 7 portent les mêmes références et ne seront pas détaillés à nouveau ici. En figure 8, la couche de résine noire 40 de la figure 7 a été remplacée par un filtre infrarouge 45 réalisé par une alternance de couches de métal et de diélectrique de la même manière que les filtres 42, 43 et 44 de la figure 7. De façon avantageuse, le filtre 45 peut être réalisé au moins en partie de façon simultanée avec les filtres 42, 43 et 44. Le filtre infrarouge 45 ne peut pas réaliser seul un filtrage sur une plage de fréquence réduite, ce qui est nécessaire pour l'utilisation du capteur d'images comme capteur de distance du type TOF. En effet, le filtre 45 ne peut pas comprendre un nombre important de couches isolantes et métalliques en raison du fait que le taux d'absorption des couches métalliques peut être important et que les épaisseurs des filtres 42, 43, 44 et 45 doivent être égales. C'est pourquoi le filtre infrarouge 45 doit être associé au filtre infrarouge correspondant à l'empilement de couches 5-1, 5-2, 5-3 et 5-4 de silicium amorphe et de couches 6-1, 6-2, 6-3 et 6-4 d'oxyde de silicium.

Selon un autre mode de réalisation, le filtre 45 est remplacé par un filtre infrarouge comprenant une alternance de couches de SiO₂ et de couches de Si amorphe. Ceci permet, de façon avantageuse, d'augmenter la transmission du filtre infrarouge réalisé sur la couche de passivation 30. De préférence, chaque filtre 42, 43 et 44 comprend des couches de silicium amorphe en plus des couches isolantes et des couches métalliques, et le filtre infrarouge peut être réalisé au moins en partie de façon simultanée avec les filtres 42, 43 et 44, les couches métalliques étant gravées au-dessus du pixel infrarouge P1 après chaque dépôt.

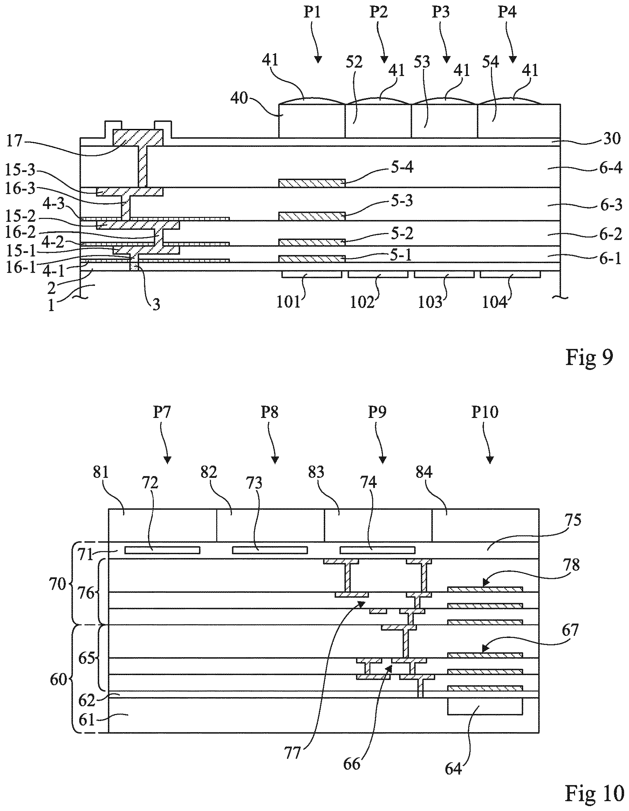

La figure 9 illustre une autre réalisation d'un capteur d'image similaire à celui de la figure 7. Les éléments communs aux figures 9 et 7 portent les mêmes références et ne seront pas détaillés à nouveau ici. En figure 9, les filtres réalisés par une alternance de couches de métal et de diélectriques 42, 43, 44 de la figure 7 ont été remplacés par des résines 52, 53 et 54 respectivement de couleurs rouge, verte et bleue.

On pourra prévoir un capteur d'image similaire aux réalisations des figures 7, 8 ou 9, dans lequel les couches (40 ou 45) déposées en surface de la couche de passivation 30 et en regard du filtre passe-bande infrarouge sont remplacées par une alternance de couches de silicium amorphe, de couches d'oxyde de silicium et, selon un mode de réalisation, de couches d'arrêt de gravure. Cette alternance forme au moins un niveau de filtre similaire aux niveaux de filtre fabriqués selon un mode de réalisation du procédé décrit précédemment qui collabore avec ces niveaux de filtre pour former le filtre passe-bande infrarouge.

On a décrit jusque maintenant des capteurs d'image comprenant un substrat semiconducteur dont une face, appelée face avant, est revêtue d'une structure d'interconnexion et est destinée à recevoir un éclairement.

On connait également des capteurs d'images comprenant un substrat semiconducteur dont une première face, appelée face avant, est revêtue d'une structure d'interconnexion, et dont une deuxième face, appelée face arrière, est destinée à recevoir un éclairement. Ce type de structure est couramment utilisé dans la technique pour des capteurs d'image du domaine du visible. Néanmoins, les zones de photodétection dédiées à l'infrarouge ont besoin d'une épaisseur de semiconducteur importante peu compatible avec la réalisation de capteurs à éclairement par la face arrière.

La figure 10 illustre l'association d'un capteur du domaine du visible à éclairement par la face arrière et d'un capteur infrarouge à éclairement par la face avant. Pour le capteur infrarouge, les niveaux d'interconnexion et de filtre sont fabriqués selon un mode de réalisation du procédé précédemment décrit.

Une première plaquette 60 comporte un substrat semiconducteur 61 revêtu d'une couche de SiO₂ 62 et comprenant une zone de photodétection 64 dédiée à l'infrarouge. Une première structure d'interconnexion 65 a été fabriquée selon un mode de réalisation du procédé décrit précédemment, comprenant des niveaux d'interconnexion 66 et des premiers niveaux de filtre infrarouge 67. Les niveaux de filtre infrarouge 67 sont disposés en regard de la zone de photodétection 64.

Une seconde plaquette 70 comporte un substrat semiconducteur aminci 71 comprenant des zones de photodétection 72, 73, 74 dédiées au visible et en configuration pour un éclairement par la face arrière, ainsi qu'un espace libre transparent 75. Selon un mode de réalisation, l'espace libre 75 correspond, de façon avantageuse, à une zone du substrat semiconducteur 71. Cette seconde plaquette 70 comprend une seconde structure d'interconnexion 76, accolée, par exemple par collage moléculaire, à la première structure d'interconnexion 65. La seconde structure 76 est fabriquée selon un mode de réalisation du procédé décrit précédemment et comprend des niveaux d'interconnexion 77 et des seconds niveaux de filtre infrarouge 78. Cette structure est disposée du côté de la face inférieure du substrat semiconducteur aminci 74. Chaque zone de photodétection est revêtue d'un filtre coloré 81, 82, 83, formant des pixels P7, P8, P9 dédiés au visible. L'espace libre 75 est situé en regard des seconds niveaux de filtre 78, et est revêtu d'une couche de résine noire 84. Les seconds niveaux de filtre 78 sont alignés et coopèrent avec les premiers niveaux de filtre infrarouge 67 pour former un unique filtre passe-bande infrarouge. L'alignement de l'espace libre 75, de la résine noire 84, des niveaux de filtre 67, 78 des deux structures accolées, avec la zone de photodétection 64 forme un pixel P10 dédié à l'infrarouge. Ce pixel P10 est similaire aux pixels dédiés à l'infrarouge des réalisations exposées précédemment. A titre de variante, la couche de résine noire 84 n'est pas présente. Dans ce cas, le substrat semiconducteur 71 peut être plus épais au niveau de la zone 75 de façon à former une surface plane avec les filtres colorés 81, 82 et 83. Ceci permet, de façon avantageuse, d'accroître l'absorption du spectre visible au niveau du pixel P10. Dans le présent mode de réalisation, un niveau de filtre infrarouge 67, 78 est formé dans chaque plaquette 60, 70. A titre de variante, un niveau de filtre infrarouge peut être réalisé seulement dans l'une des plaquettes 60 ou 70. Ceci permet de réduire le nombre d'étapes du procédé de fabrication du capteur. Toutefois, la réponse spectrale obtenue du filtre infrarouge peut alors être moins favorable que celle obtenue avec les deux niveaux de filtre infrarouge 67, 78.

Cette association forme ainsi un capteur d'image comprenant des pixels P7, P8, P9 dédiés au visible destinés à être éclairés par la face arrière et un pixel P10 dédié à l'infrarouge destiné à être éclairé par la face avant. En pratique, des configurations de ce type sont répétées périodiquement et forment une matrice de pixels d'un capteur d'image.

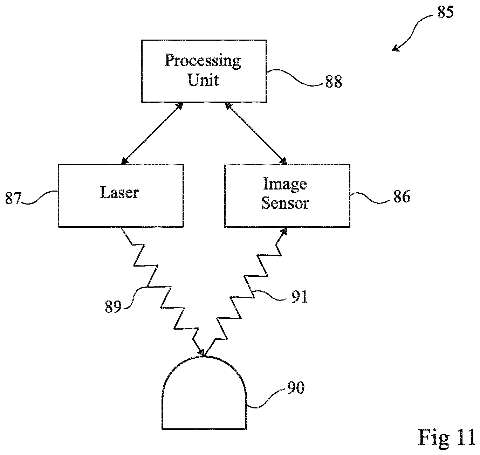

La figure 11 représente un système de mesure de distance 85 comprenant un capteur d'image 86 (Image Sensor), tel que décrit précédemment, un projecteur 87 (Laser), par exemple une source laser, et un module de traitement 88 (Processing Unit) relié à la source laser 87 et au capteur d'image 86. Le module de traitement 88 peut comprendre un processeur adapté à exécuter un programme d'ordinateur stocké dans une mémoire. Le principe de fonctionnement du système 85 est le suivant. La source laser 87 émet un rayonnement 89 à la longueur d'onde du filtre infrarouge du capteur d'image 86. Le rayonnement 89 incident est réfléchi sur un objet 90. Le capteur d'image 86 détecte le rayonnement réfléchi 91. Selon un exemple, le module de traitement 88 est adapté à déterminer le temps que le rayonnement prend pour effectuer le trajet entre l'objet 90 et le capteur d'image 86. Cette mesure de temps de vol peut être effectuée indépendamment par chaque pixel du capteur d'image, permettant ainsi d'obtenir une image tridimensionnelle complète de l'objet 90. Selon un autre mode de réalisation, la source laser 87 est adaptée à projeter un motif ou plusieurs motifs sur l'objet et le capteur d'image 86 est adapté à acquérir des images de l'objet 90 sur lequel sont projetés les motifs. Le module de traitement 88 est adapté à partir d'une analyse des images acquises à déterminer une image tridimensionnelle de l'objet 90.

Des modes de réalisation particuliers ont été décrits. Diverses variantes et modifications apparaîtront à l'homme de l'art. En particulier, les exemples de réalisations représentés en figures 7, 8 et 9 pourront être fabriqués selon le deuxième mode de réalisation du procédé décrit précédemment en relation avec les figures 4A à 4E, selon le troisième mode de réalisation du procédé décrit précédemment en relation avec les figures 5A à 5E, ou encore selon une combinaison des premier, deuxième et troisième modes de réalisation du procédé décrits précédemment.

On a décrit des dépôts de silicium amorphe pour fabriquer le filtre infrarouge, on comprendra qu'on pourra, au lieu de silicium amorphe, déposer des couches de silicium polycristallin.

On pourra également déposer une couche antireflet composée d'une couche de SiO₂ et d'une couche de SiN entre le substrat semiconducteur 1 et la couche 2 de SiO₂. Les épaisseurs de ces couches peuvent être, par exemple, de sensiblement 25 nm pour le SiO₂ et de sensiblement 50 nm pour le SiN.

Dans les réalisations exposées sur les figures 6, 7, 8, 9 et 10, on comprendra que les pixels formés par les zones de photodétection et les filtres associés pourront former une matrice de pixels selon une répétition périodique d'un motif donné, comme par exemple une matrice de Bayer.

On comprendra que les interconnexions sont associées aux zones de photodétection des substrats, et que les connexions 17 pourront être disposées en surface autour de la matrice de pixels.

## Revendications

1. Procédé de réalisation simultanée d'un filtre passe-bande dans l'infrarouge d'un côté filtre, et de niveaux d'interconnexions d'un côté interconnexion d'un capteur d'image, comprenant les étapes suivantes dans l'ordre suivant:
a) former une première couche (2) d'un matériau diélectrique d'indice de réfraction inférieur à 2,5 à la longueur d'onde de transmission maximale du filtre sur un substrat semiconducteur (1) ;
b) déposer une couche d'arrêt de gravure (4-1) ;
c) déposer au moins une couche de silicium (5-1) d'une première épaisseur ;
d) éliminer, du côté interconnexion, ladite au moins une couche de silicium (5-1) ;
e) déposer une deuxième couche du matériau diélectrique (6-1) d'une deuxième épaisseur supérieure à la première épaisseur ;
f) former dans la deuxième couche (6-1) des pistes métalliques (15-1) et des vias (16-1) d'interconnexion, du côté interconnexion ;
g) aplanir la surface à un niveau correspondant au niveau (7-1, 8-1) de la surface de la deuxième couche, là où la deuxième couche ne recouvre pas ladite au moins une couche de silicium (5-1) ; et
h) répéter les étapes b) à g) au moins une fois, les valeurs des première et deuxième épaisseurs étant sélectionnées d'une répétition à une autre, en fonction de calculs impliquant une étape de simulation et/ou en fonction des performances électriques visées, les premières épaisseurs étant sélectionnées pour former un filtre passe-bande aux propriétés désirées en fonction des deuxièmes épaisseurs sélectionnées pour obtenir des performances électriques souhaitées en matière de capacités parasites inter-niveaux.

2. Procédé selon la revendication 1, dans lequel le silicium (5-1) est du silicium amorphe.

3. Procédé selon la revendication 1 ou 2, dans lequel le matériau diélectrique est de l'oxyde de silicium.

4. Procédé selon l'une quelconque des revendications 1 à 3, dans lequel les première et deuxième couches (2, 6-1) et la couche de silicium (5-1) sont déposées à une température comprise entre 350°C et 400°C.

5. Procédé selon l'une quelconque des revendications 1 à 4, dans lequel les première et deuxième couches (2, 6-1) et la couche de silicium (5-1) sont déposées à la même température.

6. Procédé selon l'une quelconque des revendications 1 à 5, comprenant, en outre, l'étape consistant à éliminer la couche d'arrêt de gravure (4-1) du côté filtre avant de procéder à l'étape c) .

7. Procédé selon l'une quelconque des revendications 1 à 6, dans lequel ladite au moins une couche de silicium comprend une alternance (20-1) de couches de silicium amorphe et de couches d'oxyde de silicium.

8. Procédé selon l'une quelconque des revendications 1 à 7, dans lequel la couche d'arrêt de gravure (4-1) est en nitrure de silicium, en SiCH, ou en SiOCH.

9. Procédé selon l'une quelconque des revendications 1 à 8, comprenant, en outre, la formation, avant l'étape b), d'une connexion électrique (3) avec un élément du substrat semiconducteur (1) ou avec une grille d'un transistor à effet de champ formée sur le substrat semiconducteur.

## Patentansprüche

1. Verfahren zum gleichzeitigen Ausbilden eines Infrarot-Bandpassfilters auf einer Filterseite und von Verbindungsebenen auf einer Verbindungsseite eines Bildsensors, das die folgenden Schritte in der folgenden Reihenfolge aufweist:
a) Ausbilden einer ersten Schicht (2) aus einem dielektrischen Material mit einem Brechungsindex kleiner als 2,5 bei der maximalen Transmissionswellenlänge des Filters auf einem Halbleitersubstrat (1);
b) Abscheiden einer Ätzstoppschicht (4-1);
c) Abscheiden wenigstens einer Siliziumschicht (5-1) mit einer ersten Dicke;
d) Entfernen der mindestens einen Siliziumschicht (5-1) auf der Verbindungsseite;
e) Abscheiden einer zweiten Schicht des dielektrischen Materials (6-1) mit einer zweiten Dicke, die größer ist als die erste Dicke;
f) Ausbilden, in der zweiten Schicht (6-1), von Metallbahnen (15-1) und Verbindungsdurchkontaktierungen (16-1) auf der Verbindungsseite;
g) Planarisieren der Oberfläche auf ein Niveau, das dem Niveau (7-1, 8-1) der Oberfläche der zweiten Schicht entspricht, wo die zweite Schicht die wenigstens eine Siliziumschicht (5-1) nicht abdeckt; und
h) Wiederholen der Schritte b) bis g) wenigstens einmal, wobei die Werte der ersten und zweiten Dicken von einer Wiederholung zur anderen ausgewählt werden, gemäß Berechnungen, die einen Simulationsschritt implizieren, und/oder gemäß den gewünschten elektrischen Leistungen, wobei die ersten Dicken so ausgewählt werden, dass sie ein Bandpassfilter mit den gewünschten Eigenschaften in Abhängigkeit von den zweiten Dicken bilden, die so ausgewählt werden, dass gewünschte elektrische Leistungen bezüglich parasitärer Kapazitäten zwischen den Ebenen erhalten werden.

2. Verfahren nach Anspruch 1, wobei das Silizium (5-1) amorphes Silizium ist.

3. Verfahren nach Anspruch 1 oder 2, wobei das dielektrische Material Siliziumoxid ist.

4. Verfahren nach einem der Ansprüche 1 bis 3, wobei die ersten und zweiten Schichten (2, 6-1) und die Siliziumschicht (5-1) bei einer Temperatur im Bereich von 350°C bis 400°C abgeschieden werden.

5. Verfahren nach einem der Ansprüche 1 bis 4, wobei ersten und zweiten Schichten (2, 6-1) und die Siliziumschicht (5-1) bei der gleichen Temperatur abgeschieden werden.

6. Verfahren nach einem der Ansprüche 1 bis 5, wobei das Verfahren ferner den Schritt des Entfernens der Ätzstoppschicht (4-1) auf der Filterseite aufweist, bevor mit Schritt c) fortgefahren wird.

7. Verfahren nach einem der Ansprüche 1 bis 6, wobei die wenigstens eine Siliziumschicht einen Wechsel (20-1) von amorphen Siliziumschichten und Siliziumoxidschichten aufweist.

8. Verfahren nach einem der Ansprüche 1 bis 7, wobei die Ätzstoppschicht (4-1) aus Siliziumnitrid, aus SiCH oder aus SiOCH besteht.

9. Verfahren nach einem der Ansprüche 1 bis 8, ferner aufweisend das Ausbilden, vor Schritt b), einer elektrischen Verbindung (3) mit einem Element des Halbleitersubstrats (1) oder mit einem Gate eines auf dem Halbleitersubstrat ausgebildeten Feldeffekttransistors.

## Claims

1. A method of simultaneously forming an infrared bandpass filter on a filter side and interconnection levels on an interconnect side of an image sensor, comprising the steps, in the following order, of:
a) forming a first layer (2) of a dielectric material having a refraction index smaller than 2.5 at the maximum transmission wavelength of the filter on a semiconductor substrate (1);
b) depositing an etch stop layer (4-1);
c) depositing at least one silicon layer (5-1) having a first thickness;
d) removing, on the interconnect side, said at least one silicon layer (5-1);
e) depositing a second layer of the dielectric material (6-1) having a second thickness greater than the first thickness;
f) forming in the second layer (6-1) metal tracks (15-1) and interconnection vias (16-1), on the interconnect side;
g) planarizing the surface to a level corresponding to the level (7-1, 8-1) of the surface of the second layer, where the second layer does not cover said at least one silicon layer (5-1); and
h) repeating steps b) to g) at least once, the values of the first and second thicknesses being selected from one repetition to another, according to calculations implying a simulation step and/or according to the desired electric performances, the first thicknesses being selected to form a bandpass filter with the desired properties in function of the second thicknesses selected to obtain desired electric performances regarding interlevel parasitic capacitances.

2. The method of claim 1, wherein the silicon (5-1) is amorphous silicon.

3. The method of claim 1 or 2, wherein the dielectric material is silicon oxide.

4. The method of any of claims 1 to 3, wherein the first and second layers (2, 6-1) and the silicon layer (5-1) are deposited at a temperature in the range from 350°C to 400°C.

5. The method of any of claims 1 to 4, wherein the first and second layers (2, 6-1) and the silicon layer (5-1) are deposited at the same temperature.

6. The method of any of claims 1 to 5, further comprising the step of removing the etch stop layer (4-1) on the filter side before proceeding to step c).

7. The method of any of claims 1 to 6, wherein said at least one silicon layer comprises an alternation (20-1) of amorphous silicon layers and of silicon oxide layers.

8. The method of any of claims 1 to 7, wherein the etch stop layer (4-1) is made of silicon nitride, of SiCH, or of SiOCH.

9. The method of any of claims 1 to 8, further comprising the forming, before step b), of an electric connection (3) with an element of the semiconductor substrate (1) or with a gate of a field-effect transistor formed on the semiconductor substrate.
